# EUROPEAN PATENT APPLICATION

(11) **EP 2 613 348 A1**
(43) Date of publication of application: **10.07.2013**
(21) Application number: 11821728.0
(22) Date of filing: 29.08.2011
(51) Int. Cl.: H01L 23/12, H01L 23/34, H01L 23/36

(54) **MOUNTING STRUCTURE FOR ELECTRONIC COMPONENT**

(30) Priority: 30.08.2010 JP 2010191884
(71) Applicant: Keihin Corporation, Tokyo 163-0539 (JP)
(72) Inventor: ASOU, Ryuji, Shioya-gun Tochigi 329-1233 (JP)
(74) Representative: Hertz, Oliver
(86) International application number: PCT/JP2011/069445
(87) International publication number: WO 2012/029712

(57) **Abstract**

A lead (16) of an electronic component (10) is connected to a pad (24) of a substrate (20), and a solder layer (30) is correspondingly provided in a gap (G) defined between an exposed surface (14a) of a support member (14) which is a conductor, set to current-less ground potential, of the electronic component and an upper surface (22a) of a ground layer (22) of the substrate. The volume of the solder layer (30) is set to be equal to or smaller than a volume of the gap (G).

## Description

### TECHNICAL FIELD

The present invention relates to a mounting structure for an electronic component, and more particularly relates to a mounting structure for mounting an electronic component in which a semiconductor device is placed on a support member, on a substrate.

### BACKGROUND ART

In recent years, functions required for a vehicle such as an automobile are sophisticated. As a result, the number of electronic components installed on the vehicle increases, and various semiconductor devices are used in the electronic components.

At the same time, because the space for installing various component parts in the vehicle is limited, it is required to downsize, consolidate, and install these electronic components in the vehicle. Further, because the vehicle is used in an environment having large changes in temperature, humidity, and the like, these electronic components need to have sufficient durability.

Patent Document 1 relates to a semiconductor device in which a die pad mounted with a semiconductor chip is resin-sealed, and discloses a configuration including a rectangular die pad mounted with a semiconductor chip, a surface of which opposite to the surface mounted with the semiconductor chip is exposed on a lower surface of a resin package, and a folded portion in which an edge on a longer side of the die pad is folded toward the surface on which the semiconductor chip is mounted.

### PRIOR ART DOCUMENT

### PATENT DOCUMENT

Patent Document 1: Japanese Patent Application Laid-open No. H9-92757

### SUMMARY OF THE INVENTION

### PROBLEM TO BE SOLVED BY THE INVENTION

According to the consideration by the present inventors, in the configuration disclosed in Patent Document 1, the die pad is held in a stabilized state at the time of injecting resin, and it is aimed to improve the durability by improving adhesion to the package and realize a thinner package. However, because it has such a configuration that the exposed surface of the die pad is exposed to the outside, the die pad is exposed to unwanted electromagnetic noise present in the circumference to become a charged state unintentionally, and there may be unwanted influence on an operation or the like of the semiconductor chip.

Meanwhile, in the configuration disclosed in Patent Document 1, if the exposed surface of the die pad is covered with a thin resin film for a package or is enclosed, for example, by adding another electromagnetic shielding member, it can be suppressed that the electromagnetic noise is directly applied to the die pad, but the configuration itself may become cumbersome.

That is, in the mounting structure for an electronic component, a new configuration that can eliminate unwanted influence of electromagnetic noise, while sufficiently ensuring mountability on the substrate has been desired.

The present invention has been achieved to solve the above problems, and an object of the present invention is to provide a mounting structure for an electronic component that can eliminate unwanted influence of electromagnetic noise on an electronic component having a semiconductor chip and can mount the electronic component on a substrate reliably with a simple configuration.

### MEANS FOR SOLVING THE PROBLEM

To achieve the above object, a first aspect of the present invention is to provide a mounting structure for an electronic component comprising: an electronic component including a semiconductor chip, a support member on which the semiconductor chip is placed, a lead connecting to the semiconductor chip, and a case for housing the semiconductor chip, a part of the support member and a part of the lead, in which the semiconductor chip, the part of the support member, and the part of the lead are integrally packaged in the case by using resin; a substrate having a pad and a ground layer and mounted with the electronic component; and a solder layer present between the support member and the ground layer to connect the support member and the ground layer with each other, wherein the support member is a conductor and is set to current-less ground potential and housed in the case so that the part of the support member constitutes an exposed surface exposed from a surface of the case on a side of the ground layer, the lead is connected to the pad of the substrate and a gap is defined between the exposed surface of the support member and an upper surface of the ground layer corresponding thereto, and a volume of the solder layer is set to be equal to or smaller than that of the gap.

According to a second aspect of the present invention, in addition to the first aspect, the volume of the solder layer is set to a range equal to or larger than 1/2 and equal to or smaller than 2/3 of the volume of the gap.

According to a third aspect of the present invention, in addition to the first or second aspect, the shape of the support member and the shape of the ground layer are set to be substantially the same as viewed from a lamination direction in which the ground layer, the solder layer, and the support member are laminated, and the support member, the solder layer, and the ground layer are provided substantially coaxially in the lamination direction.

According to a fourth aspect of the present invention, in addition to any of the first to third aspects, an additional solder layer is provided around the solder layer in the gap.

### EFFECT OF THE INVENTION

The mounting structure for an electronic component according to the first aspect of the present invention has such a configuration that the lead of the electronic component is connected to the pad of the substrate, and the solder layer is correspondingly provided in the gap defined between the exposed surface of the support member which is a conductor, set to current-less ground potential, of the electronic component and the upper surface of the ground layer of the substrate, thereby electrically connecting the support member to the ground layer. The volume of the solder layer is set to be equal to or smaller than the volume of the gap. Accordingly, unwanted influence of electromagnetic noise on the electronic component having the semiconductor chip can be eliminated and the electronic component can be mounted reliably on the substrate with a simple configuration.

In the mounting structure for an electronic component according to the second aspect of the present invention, because the volume of the solder layer is set to a range equal to or larger than 1/2 and equal to or smaller than 2/3 of the volume of the gap, even at the time of applying the solder in a molten state, the electronic component can be mounted reliably on the substrate without being floated unwantedly, while electrically connecting the support member of the electronic component and the ground layer of the substrate with each other sufficiently.

In the mounting structure for an electronic component according to the third aspect of the present invention, the shape of the support member and the shape of the ground layer are set to be substantially the same as viewed from a lamination direction in which the ground layer, the solder layer, and the support member are laminated, and the support member, the solder layer, and the ground layer are provided substantially coaxially in the lamination direction. Therefore, after the gap is reliably defined with a relatively large volume between the exposed surface of the support member of the electronic component and the upper surface of the ground layer of the substrate, the solder layer can be reliably formed in the gap with the solder layer being position-adjusted so as not to protrude.

In the mounting structure for an electronic component according to the fourth aspect of the present invention, the additional solder layer is provided around the solder layer in the periphery of the gap. Accordingly, the additional solder layer can complement the function of the solder layer, thereby enabling to electrically connect the support member of the electronic component to the ground layer of the substrate more reliably.

### BRIEF DESCRIPTION OF THE DRAWINGS

[FIG. 1] FIG. 1 is a schematic sectional view of a mounting structure for an electronic component according to a first embodiment of the present invention.
[FIG. 2] FIG. 2 is a plan view of relevant parts of the mounting structure for an electronic component according to the embodiment.
[FIG. 3] FIG. 3 is a schematic sectional view of the mounting structure for an electronic component according to a second embodiment of the present invention.
[FIG. 4] FIG. 4 is a plan view of relevant parts of the mounting structure for an electronic component according to the embodiment.

### EMBODIMENT FOR CARRYING OUT THE INVENTION

A mounting structure for an electronic component according to respective embodiments of the present invention will be explained below in detail with reference to the accompanying drawings, appropriately. In the drawings, an x axis, a y axis, and a z axis form a three-axis orthogonal coordinate system, in which a direction of the z axis is vertical and corresponds to a lamination direction, and a plane parallel to an x-y plane is a horizontal plane.

### (First embodiment)

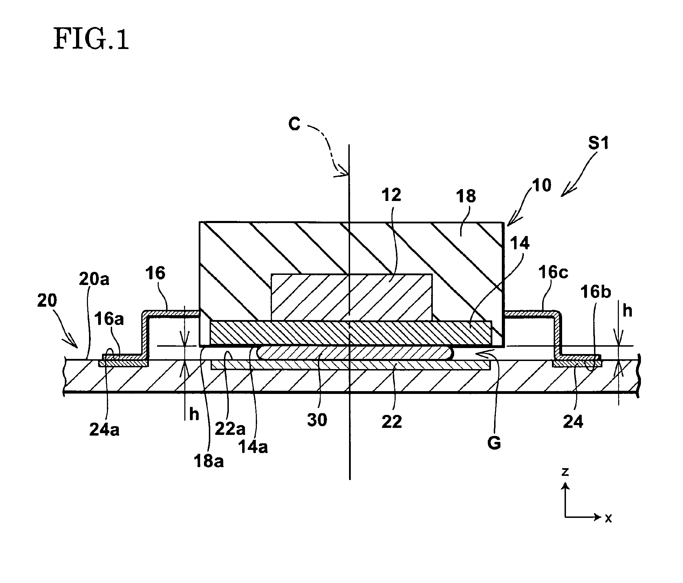

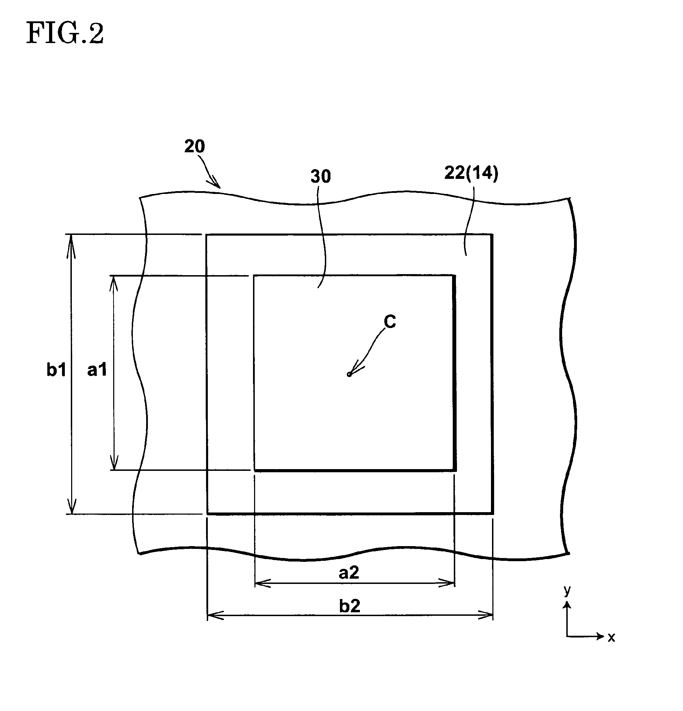

First, a mounting structure for an electronic component according to a first embodiment of the present invention is explained in detail with reference to FIGS. 1 and 2.

FIG. 1 is a schematic sectional view of the mounting structure for an electronic component according to the present embodiment. FIG. 2 is a plan view of relevant parts of the mounting structure for an electronic component according to the present embodiment, and mainly shows a state where a solder layer is formed on a ground layer of a substrate.

As shown in FIGS. 1 and 2, a mounting structure S1 for an electronic component includes an electronic component 10, a substrate 20 mounted with the electronic component 10, and a solder layer 30 connecting the electronic component 10 to the substrate 20.

Specifically, the electronic component 10 includes a semiconductor chip 12 such as a CPU (central processing unit), a support member 14 for placing and fixing the semiconductor chip 12 thereon, a lead 16 that connects to the semiconductor chip 12, and a case 18 that houses the semiconductor chip 12, a part of the support member 14, and a part of the lead 16. The semiconductor chip 12, the part of the support member 14, and the part of the lead 16 are integrally sealed and packaged in the case 18 by mold forming using synthetic resin.

The substrate 20 is typically a printed board, and includes a ground layer 22 and a pad 24, which are made of metal such as copper and exposed on an upper surface 20a of the substrate 20. A lower surface 16b of an end 16a of the lead 16 of the semiconductor chip 12 is firmly fixed by soldering or the like on an upper surface 24a of the pad 24, to connect the semiconductor chip 12 and the substrate 20 with each other electrically.

The solder layer 30 is so-called lead-free solder typically made of such as an alloy of tin, silver, and copper, or an alloy of tin and bismuth, and is present between the support member 14 of the electronic component 10 and the ground layer 22 of the substrate 20 to electrically connect the support member 14 to the ground layer 22, which is at ground potential (electric potential). On the substrate 20, the ground layer 22, the solder layer 30, and the support member 14 are laminated upward in this order along the lamination direction.

More specifically, the support member 14 of the electronic component 10 is made of metal such as an aluminum alloy typically having a cuboid shape. The support member 14 is not electrically connected singly to electrical components such as a power source and an electric circuit resultantly to be set to current-less ground potential, and is housed in the case 18 so as to constitute an exposed surface 14a on which a bottom part of the support member 14 is exposed from the lower surface 18a of the substrate 20 on the ground layer 22 side in the case 18 to form a flush surface therewith. The exposed surface 14a can be provided in a protruding condition or in a recessed condition with respect to the lower surface 18a, so long as the exposed surface 14a is exposed from the lower surface 18a of the case 18 and is reliably connected to the solder layer 30. The support member 14 is not limited to be made of metal, and can be made of a conductive material having higher electric conductivity than that of the synthetic resin, which is a material of the case 18 that covers the semiconductor chip 12, the part of the support member 14, and the part of the lead 16.

The ground layer 22 of the substrate 20 typically has a flat thin plate shape, and the exposed surface 14a of the support member 14 of the electronic component 10 and an upper surface 22a of the ground layer 22 are electrically connected, facing each other via the solder layer 30.

The lead 16 of the electronic component 10 is extended by an extended portion 16c from the case 18, and the lower surface 16b of the end 16a continuous to the extended portion 16c is positioned at a lower position than the exposed surface 14a of the support member 14 of the electronic component 10 by a distance h. Accordingly, in a state where the lower surface 16b of the end 16a of the lead 16 abuts on the upper surface 24a of the pad 24 of the substrate 20, a gap G having a height h is defined between the exposed surface 14a of the support member 14 of the electronic component 10 and the upper surface 22a of the ground layer 22 of the substrate 20, put between the exposed surface 14a and the upper surface 22a.

Furthermore, because the support member 14 of the electronic component 10 needs to be electrically connected reliably to the ground layer 22 by the solder layer 30, from this point of view, the solder layer 30 needs only to have a size sufficiently filling the gap G defined between the exposed surface 14a of the support member 14 and the upper surface 22a of the ground layer 22 of the substrate 20. Specifically, the volume of the solder layer 30 needs to be set to be equal to or smaller than the volume of the gap G. It is because when the volume of the solder layer 30 exceeds the volume of the gap G, the size itself of the solder layer 30 becomes excessive. That is, the height of the solder layer 30 becomes geometrically higher than the height h of the gap G, and the lower surface 16b of the end 16a of the lead 16 positioned at the lower position than the exposed surface 14a of the support member 14 by the distance h is alienated from the upper surface 24a of the pad 24 of the substrate 20. Accordingly, there is a high possibility that electrical connection between the lead 16 and the pad 24 is not sufficient.

Further, it is desired to set the volume of the solder layer 30 in a range equal to or larger than 1/2 and equal to or smaller than 2/3 of the volume of the gap G. It is because the solder layer 30 is formed in such a manner that after a predetermined amount of typically a lead-free solder material in a molten state is applied onto the upper surface 22a of the ground layer 22 of the substrate 20 by using an application mask beforehand, the solder material applied onto the upper surface 22a of the ground layer 22 is solidified, while the lower surface 16b of the end 16a of the lead 16 of the electronic component 10 is made to abut on the upper surface 24a of the pad 24. When this is taken into consideration, if the volume of the solder layer 30 is set to be less than 1/2 of the volume of the gap G, the size itself of the solder layer 30 is not sufficient, and there is a high possibility that the support member 14 of the electronic component 10 is not electrically connected to the ground layer 22 by the solder layer 30 sufficiently. On the other hand, if the volume of the solder layer 30 exceeds 2/3 of the volume of the gap G, the size itself of the solder layer 30 becomes excessive, and there is a possibility that the lower surface 16b of the end 16a of the lead 16 of the electronic component 10 is alienated from the upper surface 24a of the pad 24 of the substrate 20, and electrical connection between the lead 16 and the pad 24 is not sufficient.

Further, the shape of the support member 14 of the electronic component 10 and the shape of the ground layer 22 of the substrate 20 are set to be substantially the same as viewed from the lamination direction, that is, are shape-matched to have substantially the same area and the same contour shape. The support member 14 of the electronic component 10, the solder layer 30, and the ground layer 22 of the substrate 20 are preferably provided with the positions being adjusted substantially coaxially so as to have a common central axis C in the lamination direction. In such a configuration, because the exposed surface 14a of the support member 14 and the upper surface 22a of the ground layer 22 are matched with each other in terms of the shape and the position, the gap G defined and put between the exposed surface 14a of the support member 14 and the upper surface 22a of the ground layer 22 can be ensured largely, and the solder layer 30 can be reliably formed in the gap G so as not to protrude outward in a state being matched with the gap G in terms of the position. The term "substantially the same" means that these are the same with dimension accuracy, taking into consideration a tolerance in each dimension at the time of high-volume production. Further, the term "substantially coaxially" means that these are coaxial with dimension accuracy, taking into consideration the tolerance in each dimension at the time of high-volume production.

For convenience' sake, it is assumed that the exposed surface 14a of the support member 14 of the electronic component 10 is exposed in a rectangular shape on a horizontal plane from the lower surface 18a of the case 18 to form a flush surface therewith, the upper surface 22a of the ground layer 22 of the substrate 20 is exposed in a rectangular shape on the horizontal plane from the upper surface 20a of the substrate 20 to form a flush surface therewith, and the upper surface 24a of the pad 24 of the substrate 20 is exposed in a rectangular shape on the horizontal plane from the upper surface 20a of the substrate 20 to form a flush surface therewith. It is also assumed that the support member 14 and the ground layer 22, that is, the exposed surface 14a of the support member 14 and the upper surface 22a of the ground layer 22 are matched with each other in terms of the shape and the position, as described above. If it is assumed that the solder layer 30 has a cuboid shape and the lengths thereof on two sides orthogonal in the horizontal plane are a1 and a2, the volume VS thereof can be indicated as a1×a2×h. Further, if it is assumed that the lengths of the support member 14 of the electronic component 10 and the ground layer 22 of the substrate 20 on two sides orthogonal in the horizontal plane are, respectively, b1 and b2, the volume VG of the gap G in a cuboid shape can be indicated as b1×b2×h. That is, in this case, the volume VS of the solder layer 30 can be specified so as to be equal to or less than the volume VG of the gap G specified in this manner, or more preferably, to be in a range equal to or larger than 1/2 and equal to or smaller than 2/3 of the volume VG.

When the electronic component 10 in the mounting structure S1 for an electronic component configured as described above is operated, even if the electronic component 10 is exposed to electromagnetic noise from outside and the support member 14 is electrically charged, electric charge charged on the support member 14 rapidly moves to the ground layer 22 of the substrate 20 via the solder layer 30, and the charged state of the whole electronic component 10 is rapidly resolved.

The mounting structure S1 for an electronic component having the configuration described above can be preferably obtained by a manufacturing method described below.

The substrate 20 is first prepared and an application mask (not shown) made of metal or the like is placed on the upper surface 22a of the ground layer 22. The application mask has an opening that specifies the shape of the solder layer 30, and is placed on the upper surface 22a of the ground layer 22 in a state with a central axis of the opening being matched with the central axis C of the ground layer 22 so as to be substantially coaxial.

Next, the solder in the molten state is filled in the opening of the application mask placed in this manner, to be applied onto the upper surface 22a of the ground layer 22.

After the solder is applied onto the upper surface 22a of the ground layer 22, the lower surface 16b at the end 16a of the lead 16 of the electronic component 10 is made to abut on the upper surface 24a of the pad 24 of the substrate 20 to be fixed by soldering or the like, and the solder applied onto the upper surface 22a of the ground layer 22 is solidified to connect the exposed surface 14a of the support member 14 of the electronic component 10 to the upper surface 22a of the ground layer 22, thereby mounting the electronic component 10 on the substrate 20.

Timing at which the application mask is detached from the upper surface 22a of the ground layer 22 of the substrate 20 can be before the lower surface 16b at the end 16a of the lead 16 of the electronic component 10 is made to abut on the upper surface 24a of the pad 24 of the substrate 20 if the solder applied onto the upper surface 22a of the ground layer 22 is adjusted to have an appropriate viscosity, or after the solder applied onto the upper surface 22a of the ground layer 22 is solidified and the exposed surface 14a of the support member 14 of the electronic component 10 is connected to the upper surface 22a of the ground layer 22 if the application mask has a dividable configuration.

### (Second embodiment)

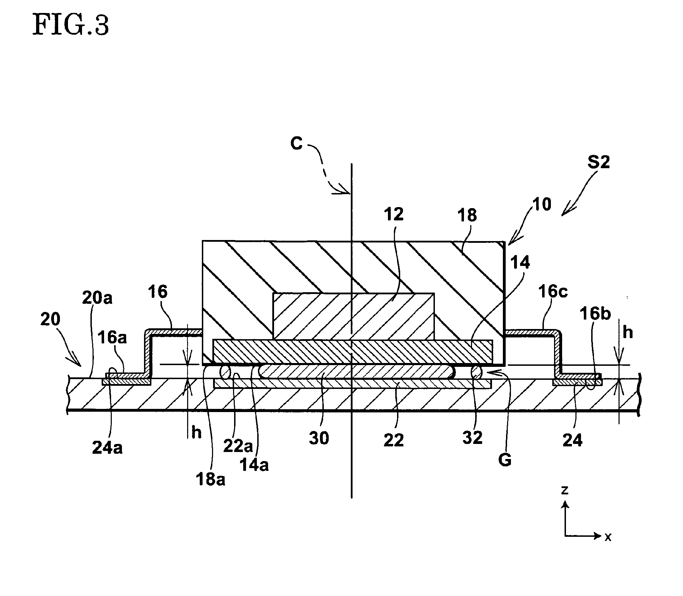

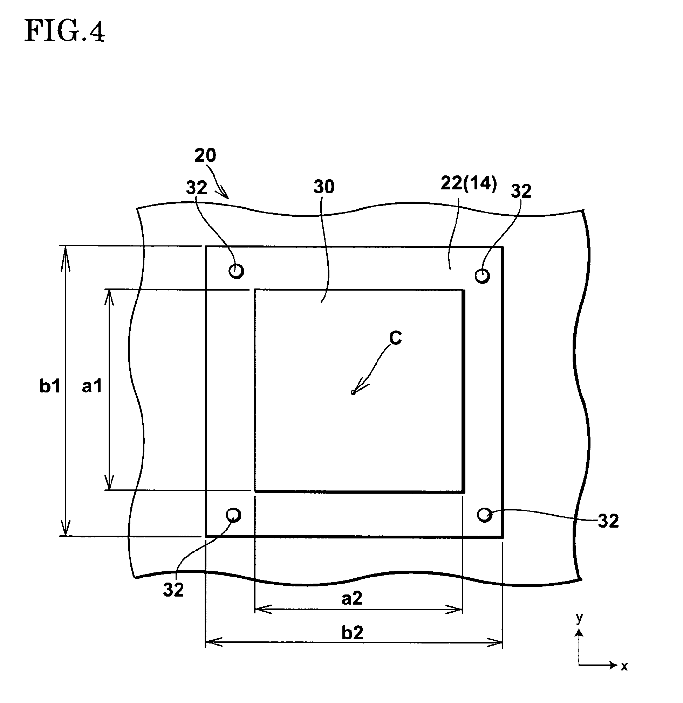

Next, a mounting structure for an electronic component according to a second embodiment of the present invention is explained in detail also with reference to FIGS. 3 and 4.

FIG. 3 is a schematic sectional view of the mounting structure for an electronic component according to the present embodiment. FIG. 4 is a plan view of relevant parts of the mounting structure for an electronic component according to the present embodiment, and shows a state where a solder layer is mainly formed on a ground layer of a substrate.

In a mounting structure S2 for an electronic component according to the present embodiment, it is a major difference from the mounting structure S1 for an electronic component according to the first embodiment that the configuration of the solder layer is different, and the other configuration is the same. Therefore, in the present embodiment, explanations are made while paying attention to different points from the first embodiment, and constituent elements identical to those of the first embodiment are denoted by like reference characters and explanations thereof will be simplified or omitted as appropriate.

As shown in FIGS. 3 and 4, in the mounting structure S2 for an electronic component, an additional solder layer 32 typically made of the same material as the solder layer 30 is provided in the periphery of the solder layer 30 in addition to the solder layer 30. The additional solder layer 32 is present between the support member 14 of the electronic component 10 and the ground layer 22 of the substrate 20, to electrically connect the support member 14 to the ground layer 22, which is at ground potential.

More specifically, the additional solder layer 32 is provided typically near four corners of the cuboid solder layer 30, that is, near four sides of the solder layer 30 extending vertically in the gap G defined and put between the exposed surface 14a of the support member 14 of the electronic component 10 and the upper surface 22a of the ground layer 22 of the substrate 20, and extends between the exposed surface 14a of the support member 14 and the upper surface 22a of the ground layer 22 of the substrate 20, thereby enabling to complement electrical connectivity between the support member 14 and the ground layer 22 freely by the solder layer 30.

That is, even if electrical resistance of the solder layer 30 increases unwantedly or the solder layer 30 itself is missing, the additional solder layer 32 can be present reliably between the exposed surface 14a of the support member 14 of the electronic component 10 and the upper surface 22a of the ground layer 22 of the substrate 20, thereby enabling to maintain electrical connection reliably between the support member 14 and the ground layer 22, and repair the connection easily after the line off or the like.

In the above configuration, the additional solder layer 32 needs only to be arranged in the periphery of the solder layer 30 in the gap G defined and put between the exposed surface 14a of the support member 14 of the electronic component 10 and the upper surface 22a of the ground layer 22 of the substrate 20, and the number thereof is not limited to four.

As explained in the first embodiment, after the solder layer 30 is formed, the solder in the molten state is injected into the periphery of the solder layer 30 and solidified in the gap G defined and put between the exposed surface 14a of the support member 14 of the electronic component 10 and the upper surface 22a of the ground layer 22 of the substrate 20 to form the additional solder layer 32, thereby enabling to obtain the mounting structure S2 for an electronic component preferably.

In the present invention, the types, arrangements, and numbers of constituent elements are not limited to those described in the above embodiments, and it is needless to mention that changes can be appropriately made without departing from the scope of the invention, such as replacing these constituent elements with other elements having equivalent operational effects.

### INDUSTRIAL APPLICABILITY

As described above, the present invention can provide a mounting structure for an electronic component that can eliminate unwanted influence of electromagnetic noise on an electronic component having a semiconductor chip and can mount the electronic component on a substrate reliably with a simple configuration. Therefore, because of its general purposes and universal characteristics, applications of the present invention can be expected in a wide range in the field of electronic components in a vehicle, for example.

## Claims

1. A mounting structure for an electronic component comprising:
an electronic component including a semiconductor chip, a support member on which the semiconductor chip is placed, a lead connecting to the semiconductor chip, and a case for housing the semiconductor chip, a part of the support member and a part of the lead, in which the semiconductor chip, the part of the support member, and the part of the lead are integrally packaged in the case by using resin;
a substrate having a pad and a ground layer and mounted with the electronic component; and
a solder layer present between the support member and the ground layer to connect the support member and the ground layer with each other, wherein
the support member is a conductor and is set to current-less ground potential and housed in the case so that the part of the support member constitutes an exposed surface exposed from a surface of the case on a side of the ground layer,
the lead is connected to the pad of the substrate and a gap is defined between the exposed surface of the support member and an upper surface of the ground layer corresponding thereto, and
a volume of the solder layer is set to be equal to or smaller than that of the gap.

2. The mounting structure for an electronic component according to claim 1, wherein the volume of the solder layer is set to a range equal to or larger than 1/2 and equal to or smaller than 2/3 of the volume of the gap.

3. The mounting structure for an electronic component according to claim 1 or 2, wherein the shape of the support member and the shape of the ground layer are set to be substantially the same as viewed from a lamination direction in which the ground layer, the solder layer, and the support member are laminated, and the support member, the solder layer, and the ground layer are provided substantially coaxially in the lamination direction.

4. The mounting structure for an electronic component according to any of claims 1 to 3, wherein an additional solder layer is provided around the solder layer in the gap.
